Europäisches Patentamt

European Patent Office

Office européen des brevets

(11) Veröffentlichungsnummer: **0 197 363**
**B1**

(12) # EUROPÄISCHE PATENTSCHRIFT

(45) Veröffentlichungstag der Patentschrift:
30.05.90

(51) Int. Cl.⁵: **G06F 11/26**, G11C 29/00

(21) Anmeldenummer: 86103574.9

(22) Anmeldetag: 17.03.86

(54) Verfahren zum Betreiben eines Halbleiterspeichers mit integrierter Paralleltestmöglichkeit und Auswerteschaltung zur Durchführung des Verfahrens.

(30) Priorität: 26.03.85 DE 3510941

(43) Veröffentlichungstag der Anmeldung:
15.10.86 Patentblatt 86/42

(45) Bekanntmachung des Hinweises auf die Patenterteilung:
30.05.90 Patentblatt 90/22

(84) Benannte Vertragsstaaten:
AT DE FR GB IT NL

(56) Entgegenhaltungen:
EP-A- 0 031 706
EP-A- 0 143 624
DE-A- 3 232 215
US-A- 3 311 890
US-A- 4 055 754
US-A- 4 363 124
US-A- 4 495 603

ELEKTRONIK, Nr. 15, 30. Juli 1982, Seiten 27-30,
München, DE; P. MATTOS et al.: " "Nibble-Mode"
beschleunigt Speicherzugriff"
PATENTS ABSTRACTS OF JAPAN, Band 6,
Nr. 62 (P-111)[940], 21. April 1982; & JP - A
- 57 3298 (NIPPON DENKI K.K.) 08.01.1982
IBM TECHNICAL DISCLOSURE BULLETIN, Band 27,
Nr. 7B, Dezember 1984, Seiten 4534-4536, New York, US;

(73) Patentinhaber: Siemens Aktiengesellschaft,
Wittelsbacherplatz 2, D-8000 München 2(DE)

(72) Erfinder: Kantz, Dieter, Dipl.-Ing., Heiglhofstrasse 47,
D-8000 München 70(DE)
Erfinder: Kuchinke, Günther, Dipl.-Ing.(FH),
Bamerstrasse 3, D-8014 Neubiberg(DE)

(56) Entgegenhaltungen: (Fortsetzung)
R.C. CADY et al.: "RAM internal parallel testing
technique"
PATENTS ABSTRACTS OF JAPAN, Band 6,
Nr. 62 (P-111)[940], 21. April 1982; & JP - A - 57 3299

**Beschreibung**

Die Erfindung betrifft ein Verfahren zum Betreiben eines Halbleiterspeichers mit integrierter Paralleltestmöglichkeit nach dem Oberbegriff des Patentanspruches 1 sowie eine Auswerteschaltung zur Durchführung des Verfahrens nach dem Oberbegriff des Patentanspruches 16.

Ein Verfahren sowie eine Auswerteschaltung der obengenannten Art sind beispielsweise aus der US-A 4 055 754 entnehmbar. Dieses Patent offenbart einen Halbleiterspeicher, bei dem unter anderem zum Zwecke der Testzeitersparnis im Halbleiterspeicher enthaltene Speicherzellen parallel getestet werden können.

Dazu ist der gesamte Speicherbereich in n einander gleiche Zellenfelder aufgeteilt. Der Wert von n ist geradzahlig. Er ist weiterhin gleich der Anzahl der gewünschten Zellenfelder und hängt davon ab, ob an Adresseingängen, über die der Halbleiterspeicher ja bekanntlich adressiert wird, einfache Adreßsignale, d.h. nur sogenannte X-Adressen bzw. Y-Adressen angelegt werden, oder aber solche Adreßsignale, die innerhalb einer Taktperiode des Halbleiterspeichers nacheinander sowohl eine X Adresse als auch eine Y-Adresse enthalten (Adreß-multiplexing). In diesem Fall kann n nur eine durch vier teilbare Zahl sein.

Des weiteren wird auch beschrieben, daß Halbleiterspeicher mehr als 1-bit breite Datenschnittstellen für Datenein- und -ausgabe haben können. Typische Organisationsformen dazu sind Datenschnittstellen in einer Breite von m = 4, 8 und 9 Bit. Je Bit einer solchen Datenschnittstelle werden zum Betreiben des bekannten Halbleiterspeichers verwendet:

1) eine erste Datenweiche zur Eingabe von zu speichernden Daten auf eine von n Datenleitungen, die dem adressierten Zellenfeld zugehörig ist (Normalbetrieb Schreiben, Testsignal inaktiv),

2) eine zweite Datenweiche zur Auswahl einer der n Datenleitungen, auf der ein ausgelesenes Speicherdatum ansteht (Normalbetrieb Lesen, Testsignal inaktiv),

3) eine dritte Datenweiche, um einzuspeichernde Testdaten parallel an alle angeschlossenen n Datenleitungen übergeben zu können (Testbetrieb Schreiben, Testsignal aktiv),

4) eine Auswerteschaltung, die im Testbetrieb Lesen beim parallelen Auslesen der gespeicherten Testdaten überprüft, ob alle parallel ausgelesenen Testdaten untereinander übereinstimmen und die in Abhängigkeit davon entweder eines der ausgelesenen, erwarteten Speicherdaten (Gutfall) an ihren Ausgang weitergibt oder dessen komplementären Wert (Fehlerfall),

5) eine vierte Datenweiche, um beim Lesen am Datenausgangsanschluß entweder das über die zweite Datenweiche ausgewählte Speicherdatum bereitzustellen (Normalbetrieb Lesen) oder (Testbetrieb Lesen) das am Ausgang der Auswerteschaltung entstandene Signal bereitzustellen.

Die bekannte Auswerteschaltung und das dabei beschriebene Testverfahren haben jedoch aufgrund der Auswerteschaltung den Nachteil, daß ein Fehler, der gleichzeitig in allen Zellenfeldern auftritt, nicht erkannt wird, sodaß kein Signal erzeugt wird, das der an den Halbleiterspeicher angeschlossene Testautomat als Fehlersignal erkennen kann.

Aufgabe der vorliegenden Erfindung ist es deshalb, ein Verfahren zum Betreiben eines Halbleiterspeichers mit integrierter Paralleltestmöglichkeit sowie eine zur Durchführung dieses Verfahrens geeignete Auswerteschaltung zu schaffen, bei der auch solche Fehler erfaßbar sind, die gleichzeitig in allen Zellenfeldern auftreten.

Diese Aufgabe wird erfindungsgemäß gelöst durch die kennzeichnenden Merkmale der Patentansprüche 1 und 16.

Vorteilhafte Ausprägungen und Weiterbildungen der Erfindung sind in Unteransprüchen gekennzeichnet.

Der der vorliegenden Erfindung zugrunde liegende Gedanke enthält folgende Überlegungen: Beim Testen des bekannten Halbleiterspeichers unter Benützen der in den Halbleiterspeicher integrierten Paralleltestmöglichkeit mittels des der US-A 4 055 754 entnehmbaren Verfahrens wird kein echter Vergleich der aus den Speicherzellen ausgelesenen Testdaten mit erwarteten Daten durchgeführt, sondern nur eine speicherinterne Plausibilitätsprüfung.

Ein echter, eindeutiger Vergleich der aus den Speicherzellen ausgelesenen Testdaten mit den vom Testautomaten erwarteten Daten unter Beibehalten des Paralleltestbetriebes ist jedoch möglich, wenn der Vergleich nicht im Testautomaten durchgeführt wird (Vergleich im Testautomat bedeutet Verzicht auf Anwendung der Paralleltestmöglichkeit), sondern im zu testenden Halbleiterspeicher (Prüfling) selbst. Dazu ist es notwendig, die vom Testautomaten erwarteten Daten (Soll-Information) dem Prüfling intern zur Verfügung zu stellen. Des weiteren ist innerhalb des Prüflings eine geeignete Auswerteschaltung zu schaffen, die jedes ausgelesene Testdatum mit der Soll-Information vergleicht und ein entsprechendes Signal als Ergebnis des Testes an einem Anschluß des Halbleiterspeichers dem Testautomaten zur Verfügung stellt. Mit einem solchen erfindungsgemäßen Verfahren und einer entsprechenden, vorteilhaft ausgestalteten Auswerteschaltung innerhalb des Halbleiterspeichers ist es dann möglich, mehrere Speicherzellen parallel, innerhalb eines einzigen Lesezyklus eindeutig zu testen, ohne die beschriebenen Nachteile in Kauf nehmen zu müssen.

Im folgenden wird die Erfindung anhand von Figuren näher beschrieben. Es zeigen

Fig. 1: die Einbindung der erfindungsgemäßen Auswerteschaltung in den bekannten Halbleiterspeicher unter Ersatz der bekannten Auswerteschaltung.

Die Figuren 2 bis 4: Verschiedene vorteilhafte Ausgestaltungen der Auswerteschaltung.

Die Figuren 5 und 6: Mögliche Ausgestaltungen zur Erzeugung eines Testsignales.

Fig. 7: Eine vorteilhafte Erzeugung eines Schreib- und eines Lesesignales.

Die Figuren 8 und 9: Zwei vorteilhafte Ausführungsformen eines Vergleichers.

Fig. 10: Verwendung eines separaten Halbleiterspeicheranschlusses für das Ausgangssignal der Auswerteschaltung.

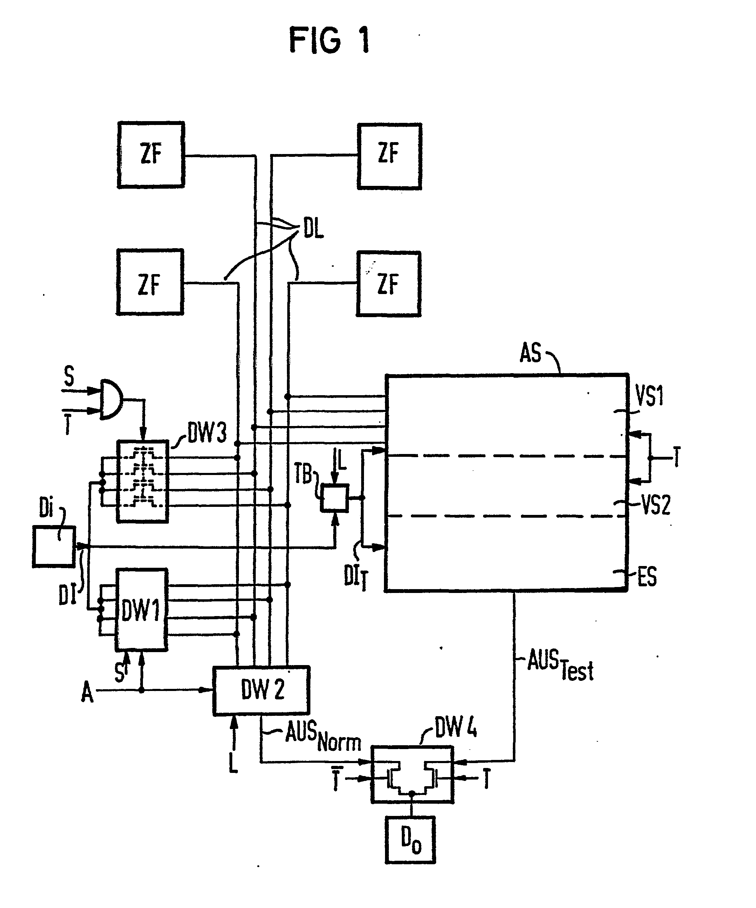

Gemäß Fig. 1 enthält ein Halbleiterspeicher mit $m = 1$. Dateneingangsanschluß $D_i$ und $m = 1$ Datenausgangsanschluß $D_o$ $n = 4$ einander gleiche Zellenfelder ZF mit Speicherzellen (z.B. bei einem "Megabit"-Speicher: Gesamtanzahl der Speicherzellen: 1024 k $\times$ 1 Bit = 1 M $\times$ 1 Bit, dies ergibt bei $n = 4$ vier Zellenfelder ZF à 256 k $\times$ 1 Bit). An jedes Zellenfeld ZF ist eine von n Datenleitungen DL angeschlossen. Diese dienen dem Einschreiben von Informationen in die Speicherzellen der Zellenfelder ZF bzw. zu deren Auslesen.

In bekannter Weise sind diese $n = 4$ Datenleitungen DL über eine erste Datenweiche DW1 mit dem Dateneingangsanschluß $D_i$ verbunden. Während eines "Normalbetriebes Schreiben" wird zum Einschreiben von Information in den Speicher durch Ansteuerung der ersten Datenweiche DW1 mittels einer bestimmten Adresseninformation, nämlich einem Adressierungssignal A, das am höchstwertigen ($A_x$) von vorhandenen Adressanschlüssen liegt, sowie mittels eines Schreibsignales S die am Dateneingangsanschluß $D_i$ anliegende Dateneingangsinformation DI auf eine der $n = 4$ vorhandenen Datenleitungen DL geschaltet, von wo aus sie in eine Speicherzelle des entsprechenden Zellenfeldes ZF eingeschrieben wird.

Entsprechend dazu sind für einen "Normalbetrieb Lesen" die Datenleitungen DL über eine zweite Datenweiche DW2 mit dem Datenausgangsanschluß $D_o$ verbunden. Diese wird adressierungsmäßig genauso angesteuert wie die erste Datenweiche DW1. Sie schaltet in Abhängigkeit von einem Lesesignal L eine der n Datenleitungen DL auf den Datenausgangsanschluß $D_o$.

Des weiteren enthält der Halbleiterspeicher gemäß Fig. 1 für einen "Testbetrieb Schreiben" parallel zur ersten Datenweiche DW1 eine dritte Datenweiche DW3, mittels derer am Dateneingangsanschluß $D_i$ anliegende Dateneingangsinformationen DI gleichzeitig auf alle $n = 4$ Datenleitungen DL übergeben werden. Die dritte Datenweiche DW3 kann beispielsweise $n = 4$ parallel geschaltete Transistoren enthalten, deren eine Seite ihrer Durchlaßstrecken gemeinsam an den Dateneingangsanschluß $D_i$ angeschlossen sind und deren andere Seiten an je eine Datenleitung DL angeschlossen sind. Gatemäßig angesteuert werden die Transistoren der dritten Datenweiche DW3 durch ein Steuersignal, das z.B. mittels eines AND-Gatters aus dem Schreibsignal S und einem Testsignal T erzeugt wird. Schreibt man über diese dritte Datenweiche DW3 Testdaten in die Speicherzellen der Zellenfelder ZF, so enthalten die entsprechenden, parallel adressierten Speicherzellen der Zellenfelder ZF untereinander dieselben Informationen, sofern der Halbleiterspeicher in Ordnung ist.

Betrachtet man nun im Testbetrieb jedes der Zellenfelder ZF als einen eigenen Speicher (Prüfling), so kann man die Testdaten, die adressierungsmäßig auf die Anzahl von Speicherzellen eines Zellenfeldes ZF abgestimmt sein müssen, gleichzeitig parallel in alle Zellenfelder ZF einschreiben.

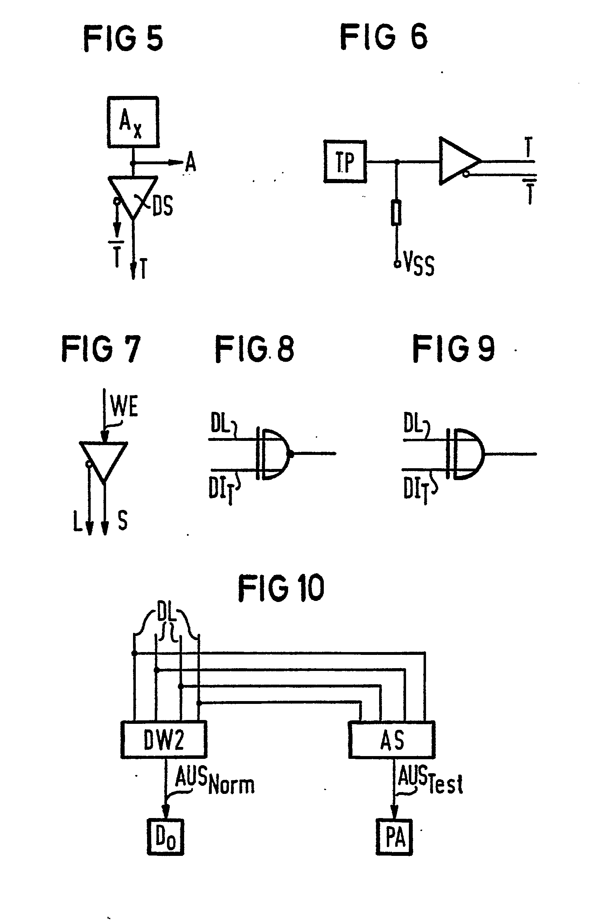

Das Testsignal T, das die dritte Datenweiche DW3 aktiviert, kann auf verschiedene Arten gewonnen werden. In einer ersten, vorteilhaften Ausführungsform gemäß Fig. 6 wird im Testfall an einen weiteren Anschluß TP ein Signal in Form eines konstanten Potentiales (z.B. logisch "1") angelegt und über einen Verstärker V stabilisiert. Im Normalbetrieb wird entweder ein konstantes Potential, z.B. mit dem Wert logisch "0", angelegt oder aber der Anschluß TP bleibt unbeschaltet. Im letzteren Falle empfiehlt es sich, den Anschluß TP hochohmig mit dem Potential ($V_{SS}$) zu verbinden, das logisch "0" entspricht. Das so erzeugte Testsignal T, das am Verstärker V abgegriffen werden kann, steuert dann beispielsweise gemeinsam mit dem Schreibsignal S die Gates der dritten Datenweiche DW3 an, sodaß deren Transistoren durchschalten. In einem invertierten Ausgang des Verstärkers V entsteht dann entsprechend ein invertiertes Signal $\overline{T}$. Diese Lösung hat einerseits den Vorteil, für das Testsignal T einen Potentialwert wählen zu können, der sonst auch zur Ansteuerung des Halbleiterspeichers verwendet wird (z.B. "TTL-Pegel"). Andererseits wird aber für den Anschluß TP ein zusätzlicher Anschluß benötigt, der unter Umständen, beispielsweise aufgrund von Gehäuseabmessungen des Halbleiterspeichers, nicht verfügbar ist.

In einer anderen vorteilhaften Ausführungsform, dargestellt in Fig. 5, wird ein Anschluß mitbenutzt, der ansonsten für den Normalbetrieb benützt wird. Als geeignetster Anschluß bietet sich ein Anschluß an, der der Ansteuerung des Halbleiterspeichers mit Adreßinformationen dient, insbesondere der für die höchstwertige X- bzw. Y bzw. X/Y-Information (beim heute üblichen Adreßmultiplexverfahren). Im Normalbetrieb wird an einen solchen Anschluß bei heute üblichen Halbleiterspeichern beispielsweise ein (höchstwertiges) Adreßsignal A mit einem "0"Pegel von 0 Volt und einem "1"-Pegel von 5 Volt angelegt. In Fig. 5 wird dieser Anschluß allgemein mit $A_x$ bezeichnet. An diesem liegt im Normalbetrieb die höchstwertige X/Y-Adreßinformation. Für den Testbetrieb wird jedoch ein Potential angelegt, das z.B. deutlich über dem "1"-Pegel des üblichen, am Adreßanschluß $A_x$ anliegenden Adreßsignales A liegt, beispielsweise 10 Volt. Eine nachgeschaltete Diskriminatorschaltung DS erkennt dieses angelegte Potential und erzeugt das halbleiterspeicherinterne Testsignal T. Diskriminatorschaltungen DS sind als solche an sich bekannt, beispielsweise in Form von Schwellwertschaltern. Bekannte Schwellwertschalter sind z.B. der DE-OS 30 30 852 und der DE-OS 33 18 564 entnehmbar. Es sind jedoch auch andere Ausgestaltungen nach dem Stande der Technik denkbar.

Des weiteren enthält der Halbleiterspeicher noch m einander gleiche erfindungsgemäße Auswerteschaltungen AS (m = Breite der Datenschnittstellen für Datenein- und -ausgabe).

Zweck jeder dieser Auswerteschaltungen AS ist es, im Testbetrieb Lesen (Testsignal T ist aktiv, Schreibsignal S inaktiv, Lesesignal L aktiv) beim Auslesen aus dem Halbleiterspeicher die auf den der jeweiligen Auswerteschaltung AS zugeordneten n Datenleitungen DL anliegenden Informationen zu übernehmen und in dem Falle, wo alle diese Informationen gleich ("Gut-Fall") einem Vergleichsdatensignal $DI_T$ sind, als Ausgangssignal $AUS_{Test}$ ein Signal mit einem ersten zeitlichen Verlauf an einem Halbleiterspeicher anschluß $D_0$ bzw. PA zur Verfügung zu stellen und in dem Falle, in dem mindestens eine dieser Informationen nicht gleich dem Vergleichsdatensignal $DI_T$ ist (Fehlerfall), als Ausgangssignal $AUS_{Test}$ ein Signal mit einem zweiten zeitlichen Verlauf am Halbleiterspeicheranschluß $D_0$ bzw. PA zur Verfügung zu stellen. In einer vorteilhaften Weiterbildung der Erfindung ist das Signal mit dem zweiten zeitlichen Verlauf komplementär zu dem mit dem ersten zeitlichen Verlauf.

Es läßt sich also kurz zusammenfassen: Gemäß Fig. 1 enthält der Halbleiterspeicher mit einer Datenschnittstelle m = 1 mit der erfindungsgemäßen Auswerteschaltung AS n = 4 einander gleiche Zellenfelder ZF. Zur Datenein- und -ausgabe ist jedem Zellenfeld ZF je eine Datenleitung DL zugeordnet.

Im Normalbetrieb Schreiben (Testsignal T inaktiv, Schreibsignal S aktiv, Lesesignal L inaktiv) des Halbleiterspeichers wird je Schreibzyklus eine an einem den Zellenfeldern ZF zugeordneten Dateneingangsanschluß $D_i$ anliegende, in eine Speicherzelle eines der Zellenfelder ZF einzuspeichernde (= einzuschreibende) Dateneingangsinformation DI über eine erste Datenweiche DW1 in Abhängigkeit von Adressierungsdaten A, dem Testsignal T und dem Schreibsignal S auf eine der Datenleitungen DL geschaltet und in einer adressierten Speicherzelle des betroffenen Zellenfeldes ZF abgespeichert.

Im Normalbetrieb Lesen (Testsignal T inaktiv, Schreibsignal S inaktiv, Lesesignal L aktiv) wird je Lesezyklus aus einer Speicherzelle eines Zellenfeldes ZF auszulesende Datenausgangsinformation über die dem angesprochenen Zellenfeld ZF zugeordnete Datenleitung DL einer zweiten Datenweiche DW2 zur Verfügung gestellt und von dieser, ebenfalls in Abhängigkeit von Adressierungsdaten A, ausgewählt und als Lesedatum $AUS_{Norm}$ weitergegeben.

Im Testbetrieb Schreiben (Testsignal T aktiv, Schreibsignal S aktiv, Lesesignal L inaktiv) des Halbleiterspeichers wird je Schreibzyklus die am Dateneingangsanschluß $D_i$ anliegende, einzuspeichernde Dateneingangsinformation DI, die bestimmungsgemäß ein Testdatum darstellt, über eine dritte Datenweiche DW3 parallel über alle n Datenleitungen DL in eine adressiert Speicherzelle jedes der n Zellenfelder ZF abgespeichert.

Im Testbetrieb Lesen (Testsignal T aktiv, Schreibsignal S inaktiv, Lesesignal L aktiv) werden je Lesezyklus zum Auslesen der gespeicherten Testdaten aus den n Zellenfeldern ZF, das parallel erfolgt, die Testdaten über alle n Datenleitungen DL an die Auswerteschaltung AS gegeben. Die Auswerteschaltung AS besitzt einen Ausgang mit einem Ausgangssignal $AUS_{Test}$. Innerhalb der Auswerteschaltung AS, die sich ja innerhalb des Halbleiterspeichers befindet, werden während jedes Lesezyklus die auf den n Datenleitungen DL, die als n parallele Eingänge für die Auswerteschaltung AS ausgebildet sind, anliegenden, aus den momentan adressierten Speicherzellen ausgelesenen Testdaten gleichzeitig und parallel mit einem Vergleichsdatensignal $DI_T$, dessen Erzeugung noch beschrieben wird, verglichen. Das Vergleichsdatensignal $DI_T$ wird der Auswerteschaltung AS über einen weiteren Eingang zugeführt. Es ist für jede Speicherzelle identisch mit dem Testdatum, das im Testbetrieb Schreiben in die beim aktuellen Lesezyklus gerade adressierten Speicherzellen geschrieben worden ist. Es wird in noch zu beschreibender Weise erzeugt und an die Auswerteschaltung AS angelegt.

Je nach Ausgestaltung der Auswerteschaltung AS wird als Ausgangssignal $AUS_{Test}$ der Auswerteschaltung AS, das als Signal mit einem ersten zeitlichen Verlauf in dem Fall, in dem je Lesezyklus alle Vergleiche positiv ausfallen ("Gut"-Fall), durch den Halbleiterspeicher an einen Halbleiteranschluß $D_0$; PA zu legen ist, das Vergleichsdatensignal $DI_T$ verwendet, das ja im vorliegenden "Gut"-Fall identisch ist mit den parallel ausgelesenen Testdaten und den ursprünglich eingespeicherten Testdaten. Es kann in diesem Fall jedoch auch eine konstante logische "0" oder "1" erzeugt werden.

Entsprechend kann in dem Fall, wo mindestens einer der Vergleiche negativ ausfällt (Fehlerfall), das Ausgangssignal $AUS_{Test}$ der Auswerteschaltung AS so ausgelegt werden, daß es als Signal mit einem zweiten zeitlichen Verlauf an den Halbleiteranschluß $D_0$; PA gelegt wird. Dieser zweite zeitliche Verlauf ist dabei vorteilhafterweise komplementär zum ersten zeitlichen Verlauf. Entsprechend der vorgenannten Fälle bezüglich des Signales mit dem ersten zeitlichen Verlauf ist es also entweder zum Vergleichsdatensignal $DI_T$ komplementär oder es ist konstant auf logisch "1" bzw. logisch "0".

Bei einer entsprechenden Ausgestaltung der Hardware und/ oder der Software eines u.a. an den Halbleiteranschluß $D_0$; PA angeschlossenen Testautomaten ist für diesen also in jedem Lesezyklus erkennbar, wie der halbleiterspeicherinterne Paralleltest ausfiel.

Je nach Ausgestaltung des bekannten Halbleiterspeichers werden die Ausgangssignale $AUS_{Norm}$ und $AUS_{Test}$ entweder über eine vierte Datenweiche DW4 in Abhängigkeit vom Testsignal T und einem zu diesem komplementären Signal $\overline{T}$ alternativ auf einen als Datenausgangsanschluß $D_0$ ausgestalteten Halbleiteranschluß geschaltet (vgl. Fig. 1) oder je Ausgangssignal $AUS_{Norm}$, $AUS_{Test}$ auf einen eigenen, der zweiten Datenweiche DW2 bzw. der Auswerteschaltung AS zugeordneten Datenausgangsanschluß $D_0$ bzw. Prüfanschluß PA gelegt (vgl. Fig. 10).

Das Testsignal T und dessen Komplementärsignal $\overline{T}$ können, wie bekannt, z. B. mittels einer Diskriminatorschaltung DS erzeugt werden (Fig. 5). Es ist jedoch auch die Verwendung eines separaten Halbleiteranschlusses als Testpin TP möglich (Fig. 6).

Als Schreibsignal S wird gemäß Fig. 7 vorteilhafterweise ein sowieso im Halbleiterspeicher vorhandenes Schreib-/Lese-Bereitschaftssignal WE unter Benützung eines Verstärkers V verwendet. Das Lesesignal L kann an einem invertierten Ausgang des Verstärkers V abgegriffen werden.

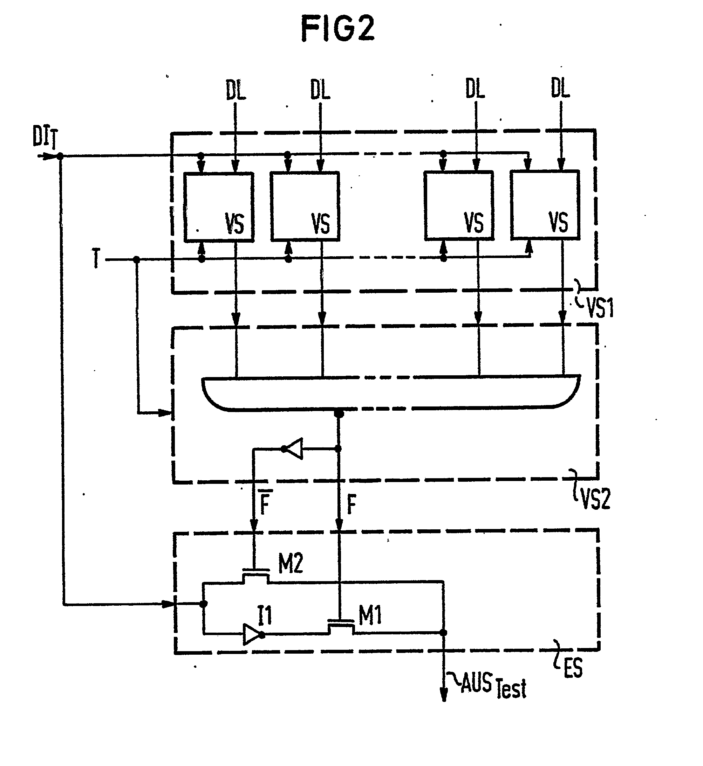

Die bei dem vorteilhaften Verfahren zu verwendende erfindungsgemäße Auswerteschaltung AS enthält gemäß den Fig. 1 und 2 im wesentlichen drei Schaltungsteile: Zwei Vergleichsschaltungen VS1, VS2 und eine Ergebnisschaltung ES. Die erste (VS1) der Vergleichsschaltungen enthält im wesentlichen je eingangsmäßig angeschlossener Datenleitung DL einen Vergleicher VS. Jeder Vergleicher VS besitzt zwei Eingänge. Die ersten dieser Eingänge der Vergleicher VS sind alle gemeinsam mit dem Vergleichsdatensignal $DI_T$ beaufschlagt. Es wird unter Verwendung des Lesesignals L in einem Testbuffer TB erzeugt. Dazu wird ein am Dateneingangsanschluß $D_i$ anliegendes Signal DI, das je Lesezyklus mit den ursprünglich eingespeicherten Testdaten identisch ist, an den Testbuffer angelegt. Der zweite Eingang jedes Vergleichers VS ist jeweils mit einer der Datenleitungen DL verbunden. In einer speziellen Ausführungsform gemäß Fig. 8 ist jeder Vergleicher VS durch ein XNOR-Gatter gebildet. Sein Ausgang ist aktiv, wenn beide Eingänge denselben logischen Pegel aufweisen. Das ist dann der Fall, wenn das auf die jeweilige Datenleitung DL ausgelesene Testdatum gleich ist dem Vergleichsdatensignal $DI_T$, was ja wiederum gleich ist dem ursprünglich eingespeicherten Testdatum. Im Fehlerfall (ausgelesenes Testdatum auf mindestens einer der Datenleitungen DL ungleich Vergleichsdatensignal $DI_T$) ist der Ausgang inaktiv.

In vorteilhafter Weise kann jeder Vergleicher VS jedoch auch, wie in Fig. 9 gezeigt, als XOR-Gatter realisiert sein. Dessen Ausgang ist dann entsprechend im Fehlerfall aktiv.

Die zweite Vergleichsschaltung VS2 enthält im wesentlichen gemäß Fig. 2 ein NAND-Gatter und einen Inverter. Das NAND-Gatter umfaßt n Eingänge, von denen jeder mit dem Ausgang eines der n Vergleicher VS der ersten Vergleichsschaltung VS1 verbunden ist. Ein erster Ausgang beinhaltet zum einen ein Fehlersignal F und ist als ein erster Eingang mit der Ergebnisschaltung ES verbunden. Zum anderen bildet er den Eingang des Inverters. Dessen Ausgang, der als zweiter Ausgang der zweiten Vergleichsschaltung VS2 ausgebildet ist, beinhaltet ein zum Fehlersignal F komplementäres Signal F. Er ist mit einem zweiten Eingang der Ergebnisschaltung ES verbunden. Die zweite Vergleichsschaltung VS2 ist also die Ausgestaltung einer Einrichtung zur Überprüfung, ob alle ihre (n) Eingänge einen ersten logischen Pegel aufweisen.

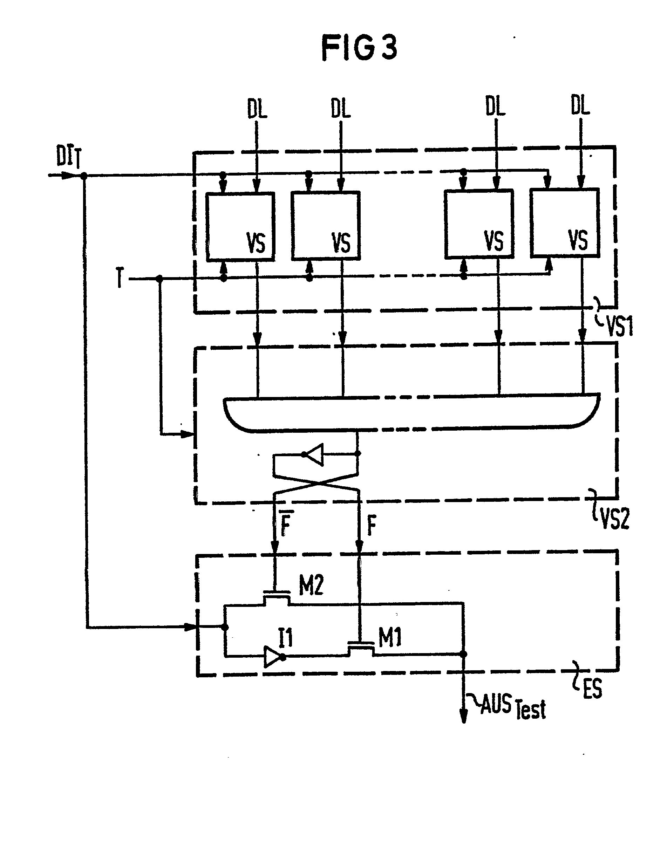

Bei der in Fig. 3 dargestellten Ausführungsform der Auswerteschaltung AS ist bei der zweiten Vergleichsschaltung VS2 anstelle des NAND-Gatters ein AND-Gatter verwendet. Dies bedingt bei Verwendung von XNOR-Gattern als Vergleicher VS, daß der Ausgang dieses AND-Gatters sowohl direkt auf den zweiten Eingang der Ergebnisschaltung ES geführt ist, als auch daß er den Eingang des Inverters bildet. Dessen Ausgang wiederum ist als Fehlersignal F zum ersten Eingang der Ergebnisschaltung ES geführt. Weitere Ausgestaltungsmöglichkeiten von Kombinationen der beschriebenen verschiedenen Ausprägungen von Vergleichern VS mit verschiedenen Ausprägungen von zweiten Vergleichsschaltungen VS2 sind möglich und dem Fachmann geläufig.

Die Ergebnisschaltung ES weist noch einen dritten Eingang auf, der in einer Ausführung gemäß Fig. 2 mit dem Vergleichsdatensignal $DI_T$ beschaltet ist, sowie einen Ausgang, der gleichzeitig den Ausgang der Auswerteschaltung AS bildet mit dem Ausgangssignal $AUS_{Test}$. Die Ergebnisschaltung ES beinhaltet zwei Transistoren M1, M2 und einen Inverter I1, der zwischen den dritten Eingang der Ergebnisschaltung ES und die Durchlaßstrecke des ersten (M1) der beiden Transistoren M1, M2 geschaltet ist. Parallel zu dieser Serienschaltung aus Inverter I1 und erstem Transistor M1 ist der zweite Transistor M2 geschaltet, dessen Gate mit dem zweiten Eingang der Ergebnisschaltung ES verbunden ist. Das Gate des ersten Transistors M1 ist mit dem ersten Eingang der Ergebnisschaltung ES verbunden.

Bei dieser Ausgestaltung der Ergebnisschaltung ES liegt also im Testbetrieb Lesen am Datenausgangsanschluß $D_o$ bzw. am Prüfanschluß PA im Gutfall als Signal mit einem ersten zeitlichen Verlauf das Vergleichsdatensignal $DI_T$ an, das ja identisch ist mit den im Testfall Schreiben eingespeicherten Testdaten und den im Testbetrieb Lesen ausgelesenen Testdaten. Im Fehlerfall wird als Signal mit einem zweiten zeitlichen Verlauf ein zum Vergleichsdatensignal $DI_T$ komplementäres Signal erzeugt.

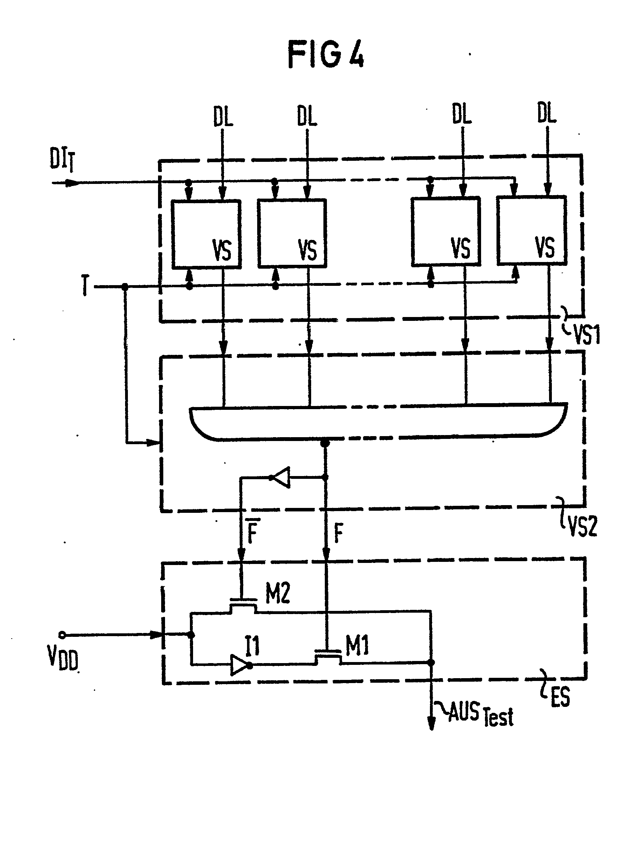

Fig. 4 zeigt eine vorteilhafte Ausführung der Ergebnisschaltung ES, bei der ihr dritter Eingang fest mit logisch "1" verschaltet ist, dargestellt als Versorgungsspannung $V_{DD}$. Dementsprechend liegt am Datenausgangsanschluß $D_o$ bzw. am Prüfanschluß PA im Gutfall eine logische "1" an, unabhängig von den eingeschriebenen bzw. ausgelesenen Testdaten und dem Vergleichsdatensignal $DI_T$. Entsprechend liegt im Fehlerfall eine logische "0" an.

Eine weitere, wegen der Analogie zur Ausführungsform gemäß Fig. 4 nicht dargestellte Ausgestaltungsmöglichkeit für die Ergebnisschaltung ES besteht darin, den dritten Eingang fest mit logisch "0" zu verbinden, was im Gutfall am Datenausgangsanschluß $D_o$ bzw. am Prüfanschluß PA eine logische "0" entstehen läßt und im Fehlerfall eine logische "1".

Entsprechende, bezüglich der Anordnung der beiden Transistoren M1, M2 und des Inverters I1 zu den beschriebenen Ausgestaltungen der Ergebnisschaltung ES inverse Ausgestaltungen durch den Durchschnittsfachmann sind selbstverständlich denkbar und liegen im Bereich dieser Erfindung.

Es liegt auch im Bereich dieser Erfindung, daß die beiden Vergleichsschaltungen VS1, VS2 und/oder das Vergleichsdatensignal $DI_T$ nur aktiviert werden, wenn das Testsignal T aktiviert ist, wie in den Fig. 1 bis 4 gezeigt.

In Analogie zur bekannten Auswerteschaltung wird auch die erfindungsgemäße Auswerteschaltung AS je Bit einer Datenein- oder -ausgabeschnittstelle verwendet: m = 8 parallele Dateneingabeanschlüsse (entsprechend acht parallelen Datenausgangsanschlüssen) bedingen m = 8 Auswerteschaltungen AS.

Vorteile dieses erfindungsgemäßen Verfahrens und der vorteilhaften Auswerteschaltung AS sind:

a) Beibehalten der Möglichkeit der Testzeitverkürzung wie bei dem bekannten Halbleiterspeicher,

b) Möglichkeit der Prüfung von redundanten Zellen wie bei üblichen Halbleiterspeichern ohne Paralleltestmöglichkeit mit redundanten Speicherzellen und bekannten Testverfahren,

c) Paralleltest ist anwendbar auf Halbleiterspeicher sowohl in Waferform als auch auf fertig montierte Bausteine,

d) keine zusätzlichen Bausteinanschlüsse notwendig, jedoch denkbar,

e) zum Testen können vorhandene Testautomaten verwendet werden, deren Adressierkapazität für das Adreßvolumen des Prüflings eigentlich nicht ausreicht (Testautomat z. B. nur geeignet für Halbleiterspeicher mit einem Adressiervolumen von 256 kB; geprüft werden soll jedoch ein 1-MB-Speicher), bei Anwendung von Paralleltesten werden jedoch entsprechend weniger Adreßsignale benötigt,

f) sichere Testaussagen, da jeder auftretende Fehler sofort erkannt wird.

## Patentansprüche

1. Verfahren zum Betreiben eines Halbleiterspeichers mit integrierter Paralleltestmöglichkeit,
- bei dem ein Halbleiterspeicher verwendet wird, der in n einander gleiche Zellenfelder (ZF) mit adressierbaren Speicherzellen eingeteilt ist, wobei jede Speicherzelle jedes Zellenfeldes (ZF) innerhalb eines Speicherzyklus gleichzeitig mit jeweils einer Speicherzelle jedes der restlichen Zellenfelder (ZF) adressierbar ist,
- bei dem während einer Prüfung (Testbetrieb) des Halbleiterspeichers die innerhalb eines Speicherzyklus zum Zwecke des Auslesens (Lesezyklus) eines eingespeicherten Testdatums adressierte Speicherzelle eines der n Zellenfelder (ZF) aufgrund eines Einschreibeverfahrens das gleiche eingespeicherte Testdatum aufweist wie jede der in den restlichen der n Zellenfelder (ZF) im selben Lesezyklus adressierten Speicherzellen in dem Falle (Gutfall), in dem der Halbleiterspeicher in Ordnung ist,
- bei dem im Gutfall durch den Halbleiterspeicher an einem Halbleiterspeicheranschluß (D$_O$; PA) ein Signal mit einem ersten zeitlichen Verlauf zur Verfügung gestellt wird, und
- bei dem in dem Fall, in dem der Halbleiterspeicher nicht in Ordnung ist (Fehlerfall) durch den Halbleiterspeicher am Halbleiteranschluß (D$_O$;

PA) ein Signal mit einem zweiten zeitlichen Verlauf zur Verfügung gestellt wird,
- bei dem innerhalb des Halbleiterspeichers im Testbetrieb die Testdaten innerhalb eines Lesezyklus aus den gleichzeitig adressierten Speicherzellen der n Zellenfelder (ZF) ausgelesen und an Vergleicher (VS) geführt werden, dadurch gekennzeichnet, daß die ausgelesenen Testdaten gleichzeitig mit einem einzigen Vergleichsdatensignal (DI$_T$) verglichen werden, das mit dem ursprünglich einzuspeichernden Testdatum identisch ist und zeitparallel von außen an alle n Vergleicher (VS) des Halbleiterspeichers geführt wird.

2. Verfahren nach Anspruch 1, **dadurch gekennzeichnet,** daß der Vergleich der ausgelesenen Testdaten in einer Auswerteschaltung (AS) erfolgt, wobei diese innerhalb des Halbleiterspeichers angeordnet ist, und einen Ausgang aufweist, der mit einem Ausgangssignal (AUS$_{Test}$) der Auswerteschaltung (AS) beschaltet wird.

3. Verfahren nach Anspruch 2, **dadurch gekennzeichnet,** daß der Ausgang der Auswerteschaltung (AS) mittelbar oder unmittelbar mit dem Halbleiteranschluß (D$_O$; PA) verbunden wird, der das Signal mit dem ersten bzw. zweiten zeitlichen Verlauf aufweist, so daß das Ausgangssignal (AUS$_{Test}$) der Auswerteschaltung (AS) gleich ist dem Signal mit dem ersten bzw. zweiten zeitlichen Verlauf.

4. Verfahren nach einem der Ansprüche 1, 2 oder 3, **dadurch gekennzeichnet,** daß das Vergleichsdatensignal (DI$_T$) von einem durch einen Testautomaten dem Halbleiterspeicher an einem Anschlußkontakt zur Verfügung gestellten Signal (DI) abgeleitet wird.

5. Verfahren nach Anspruch 4, **dadurch gekennzeichnet,** daß als Anschlußkontakt ein Dateneingangsanschluß (D$_i$) verwendet wird.

6. Verfahren nach einem der vorhergehenden Ansprüche, **dadurch gekennzeichnet,** daß das vom Testautomaten zur Verfügung gestellte Signal (DI) auch während Lesezyklen im Testbetrieb verwendet wird.

7. Verfahren nach einem der vorhergehenden Ansprüche, **dadurch gekennzeichnet,** daß das Vergleichsdatensignal (DI$_T$) in einem Testbuffer (TB) unter Verwendung eines Lesesignales (L) aus dem von Testautomaten dem Halbleiterspeicher zur Verfügung gestellten Signal (DI) erzeugt wird.

8. Verfahren nach einem der vorhergehenden Ansprüche, **dadurch gekennzeichnet,** daß als Lesesignal (L) ein im Halbleiterspeicher vorhandenen Schreib-/Lese-Bereitschaftssignal (WE) komplementäres Signal verwendet wird.

9. Verfahren nach einem der vorhergehenden Ansprüche, **dadurch gekennzeichnet,** daß das vom Testautomaten zur Verfügung gestellte Signal (DI) je Lesezyklus dem ursprünglich während eines Schreibzyklus in den Halbleiterspeicher einzuspeichernden und im Lesezyklus auszulesenden Testdatum entspricht.

10. Verfahren nach einem der vorhergehenden Ansprüche, **dadurch gekennzeichnet,** daß als Halbleiteranschluß (D$_O$; PA) für das zur Verfügung gestellte Signal ein Datenausgangsanschluß (D$_o$) verwendet wird, an dem bei einem Normalbetrieb des Halbleiterspeichers die in einem Lesezyklus ausgelesene Information anliegt.

11. Verfahren nach einem der Ansprüche 1 bis 10, **dadurch gekennzeichnet,** daß als am Halbleiterspeicheranschluß (D$_o$; PA) zur Verfügung gestelltes Signal mit dem ersten zeitlichen Verlauf das Vergleichsdatensignal (DI$_T$) verwendet wird, wobei dieses mit dem ausgelesenen Testdatum und dem ursprünglich eingespeicherten Testdatum identisch ist.

12. Verfahren nach einem der Ansprüche 1 bis 10, **dadurch gekennzeichnet,** daß als am Halbleiterspeicheranschluß (D$_o$; PA) zur Verfügung gestelltes Signal mit dem ersten zeitlichen Verlauf ein Signal mit dem konstanten Wert logisch "1" verwendet wird.

13. Verfahren nach einem der Ansprüche 1 bis 10, **dadurch gekennzeichnet,** daß als am Halbleiterspeicheranschluß (D$_o$; PA) zur Verfügung gestelltes Signal mit dem ersten zeitlichen Verlauf ein Signal mit dem konstanten Wert logisch "0" verwendet wird.

14. Verfahren nach einem der vorhergehenden Ansprüche, **dadurch gekennzeichnet,** daß als Signal mit dem zweiten zeitlichen Verlauf ein Signal erzeugt wird, das komplementär zum Signal mit dem ersten zeitlichen Verlauf ist.

15. Verfahren nach einem der vorhergehenden Ansprüche, **dadurch gekennzeichnet,** daß die Auswerteschaltung (AS) nur im Testbetrieb durch ein aktiviertes Testsignal (T) aktiviert wird.

16. Auswerteschaltung zur Durchführung des Verfahrens gemäß einem der vorhergehenden Ansprüche, **dadurch gekennzeichnet,**
 – daß sie eine erste Vergleichsschaltung (VS1) aufweist, die n Vergleicher (VS) enthält mit jeweils einem ersten Eingang, einem zweiten Eingang und einem Ausgang,
 – daß alle ersten Eingänge der Vergleicher (VS) miteinander verbunden sind und einen Eingang für ein Vergleichsdatensignal (DI$_T$) bilden,
 – daß der zweite Eingang eines jeden Vergleichers (VS) jeweils mit einer von n Datenleitungen (DL) verbunden ist, wobei jede Datenleitung zu einem der n Zellenfelder führt,
 – daß der Ausgang jedes der n Vergleicher (VS) gleichzeitig einen von n Eingängen einer zweiten Vergleichsschaltung (VS2) bildet,
 – daß die zweite Vergleichsschaltung (VS2) eine Einrichtung aufweist zur Überprüfung, ob alle ihre n Eingänge einen ersten logischen Pegel aufweisen,
 – daß die zweite Vergleichsschaltung (VS2) einen ersten Ausgang für ein Fehlersignal (F) aufweist, das in dem Falle, in dem alle ihre n Eingänge den ersten logischen Pegel aufweisen, deaktiviert ist und ansonsten aktiviert ist, und daß die zweite Vergleichsschaltung (VS2) einen zweiten Ausgang für ein zum Fehlersignal (F) komplementäres Signal ($\overline{F}$) aufweist,
 – daß die Auswerteschaltung (AS) des weiteren eine Ergebnisschaltung (ES) aufweist, mit einem Ausgang für ein Ausgangssignal (AUS$_{Test}$) der

Auswerteschaltung (AS), das in dem Falle (Gutfall), in dem der Halbleiterspeicher in Ordnung ist, als Signal mit einem ersten zeitlichen Verlauf an einem Halbleiteranschluß (D$_o$; PA) zur Verfügung steht und daß in dem Falle (Fehlerfall), in dem der Halbleiterspeicher nicht in Ordnung ist, als Signal mit einem zweiten zeitlichen Verlauf am Halbleiteranschluß (D$_o$; PA) zur Verfügung steht,
 – daß die Ergebnisschaltung (ES) außerdem einen ersten und einen zweiten Eingang aufweist, die mit den beiden Ausgängen der zweiten Vergleichsschaltung (VS2) verbunden sind sowie einen dritten Eingang für ein Signal, das im Testbetrieb den Zustand des Halbleiteranschlusses (D$_o$; PA) bestimmt.

17. Auswerteschaltung nach Anspruch 16, **dadurch gekennzeichnet,** daß jeder Vergleicher (VS) ein XNOR-Gatter ist.

18. Auswerteschaltung nach Anspruch 16, **dadurch gekennzeichnet,** daß jeder Vergleicher (VS) ein XOR-Gatter ist.

19. Auswerteschaltung nach einem der Ansprüche 16 bis 18, **dadurch gekennzeichnet,** daß die zweite Vergleichsschaltung (VS2) ein NAND-Gatter mit n Eingängen und einem Ausgang enthält, wobei dieser Ausgang den einen Ausgang der zweiten Vergleichsschaltung (VS2) bildet.

20. Auswerteschaltung nach einem der Ansprüche 16 bis 18, **dadurch gekennzeichnet,** daß die zweite Vergleichsschaltung (VS2) ein AND-Gatter mit n Eingängen und einem Ausgang enthält, wobei dieser Ausgang den einen Ausgang der zweiten Vergleichsschaltung (VS2) bildet.

21. Auswerteschaltung nach einem der Ansprüche 16 bis 20, **dadurch gekennzeichnet,** daß die zweite Vergleichsschaltung (VS2) des weiteren einen Inverter enthält, dessen Eingang mit dem einen Ausgang der zweiten Vergleichsschaltung (VS2) verbunden ist und dessen Ausgang den anderen Ausgang der zweiten Vergleichsschaltung (VS2) bildet.

22. Auswerteschaltung nach einem der Ansprüche 16 bis 21, **dadurch gekennzeichnet,** daß die Ergebnisschaltung (ES) zwei Transistoren (M1, M2) und einen Inverter (I1) aufweist, daß der Inverter (I1) ausgangsmäßig mit einem Anschluß der Durchlaßstrecke des einen Transistors (M1) verbunden ist, daß ein anderer Anschluß der Durchlaßstrecke dieses Transistors (M1) den Ausgang der Ergebnisschaltung (ES) bildet und daß dieser Transistor (M1) gatemäßig als der erste Eingang der Ergebnisschaltung (ES) mit dem einen Ausgang der zweiten Vergleichsschaltung (VS2) verbunden ist.

23. Auswerteschaltung nach einem der Ansprüche 16 bis 22, **dadurch gekennzeichnet,** daß der andere Transistor (M2) der Ergebnisschaltung (ES) mit seiner Durchlaßstrecke zwischen den dritten Eingang der Ergebnisschaltung (ES) und den Ausgang der Ergebnisschaltung (ES) geschaltet ist und daß dieser andere Transistor (M2) gatemäßig als der zweite Eingang der Ergebnisschaltung (ES) mit dem anderen Ausgang der zweiten Vergleichsschaltung (VS2) verbunden ist.

24. Auswerteschaltung nach einem der Ansprüche 16 bis 23, **dadurch gekennzeichnet,** daß der Inverter (I1) der Ergebnisschaltung (ES) eingangsmäßig mit dem dritten Eingang der Ergebnisschaltung (ES) verbunden ist.

25. Auswerteschaltung nach einem der Ansprüche 16 bis 24, **dadurch gekennzeichnet,** daß der dritte Eingang der Ergebnisschaltung (ES) mit dem Vergleichsdatensignal (DI$_T$) beschaltest ist.

26. Auswerteschaltung nach einem der Ansprüche 16 bis 24, **dadurch gekennzeichnet,** daß der dritte Eingang der Ergebnisschaltung (ES) mit einem festen Potential (V$_{DD}$) verbunden ist, das einer logischen "1" entspricht.

27. Auswerteschaltung nach einem der Ansprüche 16 bis 24, **dadurch gekennzeichnet,** daß der dritte Eingang der Ergebnisschaltung (ES) mit einem festen Potential verbunden ist, das einer logischen "0" entspricht.

28. Auswerteschaltung nach einem der Ansprüche 16 bis 27, **dadurch gekennzeichnet,** daß zur Erzeugung des Vergleichsdatensignales (DI$_T$) ein Testbuffer (TB) vorgesehen ist, der mit Hilfe eines aktivierten Lesesignales (L) während eines Lesezyklus, innerhalb dessen Information aus dem Halbleiterspeicher ausgelesen werden soll, eine eingangsseitig am Testbuffer (TB) anliegende Information übernimmt und diese ausgangsseitig als Vergleichsdatensignal (DI$_T$) der ersten Vergleichsschaltung (VS1) und der Ergebnisschaltung (ES) zur Verfügung stellt.

29. Auswerteschaltung nach einem der Ansprüche 16 bis 28, **dadurch gekennzeichnet,** daß die am Testbuffer (TB) eingangsseitig anliegende Information ein Signal (DI) ist, das an einem mit dem Testbuffer (TB) verbundenen Dateneingangsanschluß (D$_i$) anliegt und das innerhalb des Lesezyklus identisch ist mit einem Testdatum, das aus dem Halbleiterspeicher ausgelesen werden soll.

30. Auswerteschaltung nach einem der Ansprüche 16 bis 29, **dadurch gekennzeichnet,** daß das Lesesignal (L) während eines Lesezyklus aktiviert ist und daß es von einem im Halbleiterspeicher vorhandenen Schreib-/Lese-Bereitschaftssignal (WE) durch Komplementierung abgeleitet ist.

31. Auswerteschaltung nach einem der Ansprüche 16 bis 30, **dadurch gekennzeichnet,** daß ein Schreibsignal (S) während eines Schreibzyklus aktiviert ist und daß es von dem im Halbleiterspeicher vorhandenen Schreib-/Lese-Bereitschaftssignal (WE) abgeleitet ist.

32. Auswerteschaltung nach einem der Ansprüche 16 bis 31, **dadurch gekennzeichnet,** daß die beiden Vergleichsschaltungen (VS1, VS2) nur im Testfalle durch ein Testsignal (T) aktiviert werden.

## Claims

1. Method of operating a semiconductor memory with a facility for performing integrated parallel testing,
   - in which a semiconductor memory which is subdivided into n identical cell fields (ZF) having addressable storage cells is used, each storage cell of each cell field (ZF) being addressable within a storage cycle simultaneously with a respective storage cell of each of the remaining cell fields (ZF);
   - in which, during a test (testing operation) of the semiconductor memory, in the case ("go" case) in which the semiconductor memory is in order, the storage cell of one of the n cell fields (ZF) which is addressed within a storage cycle for the purpose of reading out (reading cycle) a stored test datum has, due to a writing-in process, the same stored test datum as each of the storage cells addressed in the same read cycle of the remaining n cell fields (ZF),
   - in which, in the "go" case, a signal with a first waveform is made available by the semiconductor memory at a semiconductor memory terminal (D$_O$; PA),
   - in which, in the case in which the semiconductor memory is not in order ("no-go" case), a signal with a second waveform is made available by the semiconductor memory at the semiconductor terminal (D$_O$; PA), and
   - in which, within the semiconductor memory in testing operation, the test data within a read cycle are read out from the simultaneously addressed storage cells of the n cell fields (ZF) and passed to comparators (VS), characterized in that the read-out test data are simultaneously compared with a single comparison data signal (DI$_T$), which is identical to the original test datum to be stored and is passed at parallel times from outside to all n comparators (VS) of the semiconductor memory.

2. Method according to Claim 1, characterized in that the comparison of the read-out test data is performed in an evaluation circuit (AS), the latter being arranged within the semiconductor memory and having an output to which an output signal (AUS$_{Test}$) of the evaluation circuit (AS) is applied.

3. Method according to Claim 2, characterized in that the output of the evaluation circuit (AS) is connected indirectly or directly to the semiconductor terminal (D$_O$; PA) which has the signal with the first and the second waveform, respectively, so that the output signal (AUS$_{Test}$) of the evaluation circuit (AS) is the same as the signal with the first and second waveform, respectively.

4. Method according to one of Claims 1, 2 or 3, characterized in that the comparison data signal (DI$_T$) is derived from a signal (DI) made available to the semiconductor memory at a terminal contact by an automatic tester.

5. Method according to Claim 4, characterized in that a data input terminal (D$_i$) is used as terminal contact.

6. Method according to one of the preceding claims, characterized in that the signal (DI) made available by the automatic tester is also used during read cycles in testing operation.

7. Method according to one of the preceding claims, characterized in that the comparison data signal (DI$_T$) is generated in a test buffer (TB) by using a read signal (L) from the signal (DI) made available to the semiconductor memory by the automatic tester.

8. Method according to one of the preceding claims, characterized in that a signal complementary to a write/read standby signal (WE) present in the semiconductor memory is used as read signal (L).

9. Method according to one of the preceding claims, characterized in that the signal (DI) made available by the automatic tester corresponds per read cycle to the test datum which is to be stored originally during a write cycle into the semiconductor memory and is to be read out in the read cycle.

10. Method according to one of the preceding claims, characterized in that a data output terminal ($D_O$) at which the information read out in a read cycle in a normal operation of the semiconductor memory is present is used as semiconductor terminal ($D_O$; PA) for the signal made available.

11. Method according to one of Claims 1 to 10, characterized in that the comparison data signal ($DI_T$) is used as the signal with the first waveform made available at the semiconductor memory terminal ($D_O$; PA), the said comparison data signal being identical to the read-out test datum and the originally stored test datum.

12. Method according to one of Claims 1 to 10, characterized in that a signal with the constant value logical "1" is used as signal with the first waveform made available at the semiconductor memory terminal ($D_O$; PA).

13. Method according to one of Claims 1 to 10, characterized in that a signal with the constant value logical "0" is used as signal with the first waveform made available at the semiconductor memory terminal ($D_O$; PA).

14. Method according to one of the preceding claims, characterized in that a signal which is complementary to the signal with the first waveform is generated as signal with the second waveform.

15. Method according to one of the preceding claims, characterized in that the evaluation circuit (AS) is activated by an activated test signal (T) only in testing operation.

16. Evaluation circuit for carrying out the process according to one of the preceding claims, characterized

— in that it has a first comparator circuit (VS1), which includes n comparators (VS) each with a first input, a second input and an output,

— in that all of the first inputs of the comparators (VS) are interconnected and form an input for a comparison data signal ($DI_T$),

— in that the second input of each comparator (VS) is connected to a respective one of n data lines (DL), each data line leading to one of the n cell fields,

— in that the output of each of the n comparators (VS) simultaneously forms one of n inputs of a second comparator circuit (VS2),

— in that the second comparator circuit (VS2) has a device for checking whether all of its n inputs have a first logical level,

— in that the second comparator circuit (VS2) has a first output for an error signal (F) which is deactivated in the case in which all of its n inputs have the first logical level and is otherwise activated, and in that the second comparator circuit (VS2) has a second output for a signal ($\overline{F}$) complementary to the error signal (F),

— in that the evaluation circuit (AS) also has a result circuit (ES), with an output for an output signal ($AUS_{Test}$) of the evaluation circuit (AS), which signal is available as signal with a first waveform at a semiconductor terminal ($D_O$; PA) in the case ("go" case) in which the semiconductor memory is in order and which is available as signal with a second waveform at the semiconductor terminal ($D_O$; PA) in the case ("no-go" case) in which the semiconductor memory is not in order,

— in that the result circuit (ES) also has a first and a second input, which are connected to the two outputs of the second comparator circuit (VS2), as well as a third input for a signal which determines the status of the semiconductor terminal ($D_O$; PA) in testing operation.

17. Evaluation circuit according to Claim 16, characterized in that each comparator (VS) is an XNOR gate.

18. Evaluation circuit according to Claim 16, characterized in that each comparator (VS) is an XOR gate.

19. Evaluation circuit according to one of Claims 16 to 18, characterized in that the second comparator circuit (VS2) is a NAND gate with n inputs and one output, the said output forming the one output of the second comparator circuit (VS2).

20. Evaluation circuit according to one of Claims 16 to 18, characterized in that the second comparator circuit (VS2) is an AND gate with n inputs and one output, the said output forming the one output of the second comparator circuit (VS2).

21. Evaluation circuit according to one of Claims 16 to 20, characterized in that the second comparator circuit (VS2) also includes an inverter, the input of which is connected to the one output of the second comparator circuit (VS2) and the output of which forms the other output of the second comparator circuit (VS2).

22. Evaluation circuit according to one of Claims 16 to 21, characterized in that the result circuit (ES) has two transistors (M1, M2) and an inverter (I1), in that the inverter (I1) is connected output-wise to a terminal of the conduction path of the one transistor (M1), in that another terminal of the conduction path of the said transistor (M1) forms the output of the result circuit (ES) and in that the said transistor (M1) is connected gate-wise as the first input of the result circuit (ES) to the one output of the second comparator circuit (VS2).

23. Evaluation circuit according to one of Claims 16 to 22, characterized in that the other transistor (M2) of the result circuit (ES) is connected by its conduction path between the third input of the result circuit (ES) and the output of the result circuit (ES) and in that the said other transistor (M2) is connected gate-wise as the second input of the result circuit (ES) to the other output of the second comparator circuit (VS2).

24. Evaluation circuit according to one of Claims 16 to 23, characterized in that the inverter (I1) of the result circuit (ES) is connected input-wise to the third input of the result circuit (ES).

25. Evaluation circuit according to one of Claims 16 to 24, characterized in that the third input of the result circuit (ES) is connected to the comparison data signal (DI$_T$).

26. Evaluation circuit according to one of Claims 16 to 24, characterized in that the third input of the result circuit (ES) is connected to a fixed potential (V$_{DD}$) which corresponds to a logical "1".

27. Evaluation circuit according to one of Claims 16 to 24, characterized in that the third input of the result circuit (ES) is connected to a fixed potential which corresponds to a logical "0".

28. Evaluation circuit according to one of Claims 16 to 27, characterized in that a test buffer (TB) is provided for generating the comparison data signal (DI$_T$), which buffer receives information present on the input side of the test buffer (TB) with the aid of an activated read signal (L) during a read cycle within which information is to be read out of the semiconductor memory, and makes it available on the output side as a comparison data signal (DI$_T$) of the first comparator circuit (VS1) and of the result circuit (ES).

29. Evaluation circuit according to one of Claims 16 to 28, characterized in that the information present at the test buffer (TB) on the input side is a signal (DI) which is present at a data input terminal (D$_i$) connected to the test buffer (TB) and is identical within the read cycle with a test datum which is to be read out from the semiconductor memory.

30. Evaluation circuit according to one of Claims 16 to 29, characterized in that the read signal (L) is activated during a read cycle and in that it is derived by complementation from a write/read standby signal (WE) present in the semiconductor memory.

31. Evaluation circuit according to one of Claims 16 to 30, characterized in that a write signal (S) is activated during a write cycle and in that it is derived from the write/read standby signal (WE) present in the semiconductor memory.

32. Evaluation circuit according to one of Claims 16 to 31, characterized in that the two comparator circuits (VS1, VS2) are activated by a test signal (T) only in the testing case.

## Revendications

1. Procédé pour l'exploitation d'une mémoire à semiconducteurs comportant une possibilité intégrée d'essai en parallèle, selon lequel
   - on utilise une mémoire à semiconducteurs qui est subdivisée en n zones de mémoire identiques (ZF) comportant des cellules de mémoire adressables, chaque cellule de mémoire de chaque zone de cellule (ZF) pouvant être adressée simultanément, au cours d'un cycle de mémoire, avec respectivement une cellule de mémoire de chacune des autres zones de cellules (ZF),
   - pendant un contrôle (fonctionnement d'essai) de la mémoire à semiconducteurs, la cellule de mémoire, adressée au cours d'un cycle de mémorisation pour réaliser la lecture (cycle de lecture) d'une donnée d'essai mémorisée, de l'une des n zones de cellules (ZF), possède, sur la base d'un procédé d'enregistrement, la même donnée d'essai mémorisée que chacune des cellules de mémoire adressées dans les zones restantes des n zones de cellules (ZF), lors du même cycle de lecture, dans le cas (cas bon) où la cellule de mémoire est en ordre,
   - dans le cas bon, la cellule de mémoire délivre, sur une borne (D$_o$; PA), un signal possédant une première variation de temps, et
   - dans le cas où la mémoire à semiconducteurs n'est pas en ordre (cas d'erreur), la mémoire à semiconducteurs délivre sur la borne (D$_o$; PA), un signal possédant une seconde variation dans le temps,
   - à l'intérieur de la mémoire à semiconducteurs, lors du fonctionnement d'essai, les données d'essai sont lues pendant un cycle de lecture à partir des cellules de mémoire, adressées simultanément, des n zones de cellules (ZF) et sont envoyées à un comparateur (VS),
caractérisé par le fait que les données d'essai lues sont comparées simultanément à un signal unique de données de comparaison (DI$_T$), qui est identique à la donnée d'essai devant être mémorisée à l'origine et est envoyé depuis l'extérieur, simultanément en parallèle à la totalité des n comparateurs (VS) de la mémoire à semiconducteurs.

2. Procédé suivant la revendication 1, caractérisé par le fait que la comparaison des données d'essai lues est exécutée dans un circuit d'évaluation (AS), qui est disposé à l'intérieur de la mémoire à semiconducteurs et possède une sortie qui délivre un signal de sortie (AUS$_{essai}$) du circuit d'évaluation (AS).

3. Procédé suivant la revendication 2, caractérisé par le fait que la sortie du circuit d'évaluation (AS) est reliée directement ou indirectement à la borne (D$_o$; PA) de la mémoire à semiconducteurs qui délivre le signal présent dans la première ou la seconde variation dans le temps, de sorte qu'un signal de sortie (AUS$_{essai}$) du circuit d'évaluation (AS) est égal au signal possédant la première ou la seconde variation dans le temps.

4. Procédé suivant l'une des revendications 1, 2 ou 3, caractérisé par le fait que le signal de données de comparaison (DI$_T$) est dérivé d'un signal (DI) délivré par un dispositif automatique d'essai à la mémoire à semiconducteurs, au niveau d'un contact de raccordement.

5. Procédé suivant la revendication 4, caractérisé par le fait qu'on utilise comme contact de raccordement une borne (D$_i$) d'entrée des données.

6. Procédé suivant l'une des revendications précédentes, caractérisé par le fait que le signal (DI) délivré par le dispositif automatique d'essai, est utilisé également pendant des cycles de lecture lors du fonctionnement d'essai.

7. Procédé suivant l'une des revendications précédentes, caractérisé par le fait que le signal de données de comparaison (DI$_T$) est produit dans un tampon d'essai (TB) moyennant l'utilisation d'un signal de lecture (L) obtenu à partir du signal (DI) délivré par le dispositif automatique d'essai à la mémoire à semiconducteurs.

8. Procédé suivant l'une des revendications précédentes, caractérisé par le fait qu'on utilise comme signal de lecture (L) un signal complémentaire du signal (WE) de préparation d'enregistrement/lecture présent dans la mémoire à semiconducteurs.

9. Procédé suivant l'une des revendications précédentes, caractérisé par le fait que le signal (DI) délivré par le dispositif automatique d'essai correspond, pour chaque cycle de lecture, à la donnée d'essai qui doit être mémorisée à l'origine pendant un cycle d'enregistrement dans la mémoire à semiconducteurs et doit être lue pendant le cycle de lecture.

10. Procédé suivant l'une des revendications précédentes, caractérisé par le fait qu'on utilise comme borne ($D_0$; PA) de la mémoire à semiconducteurs pour le signal délivré, une borne de sortie des données ($D_0$), à laquelle est appliquée l'information lue lors d'un cycle de lecture, dans le cas d'un fonctionnement normal de la mémoire à semiconducteurs.

11. Procédé suivant l'une des revendications 1 à 10, caractérisé par le fait qu'on utilise comme signal délivré sur la borne ($D_0$; PA) de la mémoire à semiconducteurs et possédant la première variation dans le temps, le signal de données de comparaison ($DI_T$), qui est identique à la donnée d'essai lue et à la donnée d'essai mémorisée à l'origine.

12. Procédé suivant l'une des revendications 1 à 10, caractérisé par le fait qu'on utilise comme signal délivré sur la borne ($D_0$; PA) de la mémoire à semiconducteurs et possédant la première variation dans le temps, un signal possédant la valeur logique constante "1".

13. Procédé suivant l'une des revendications 1 à 10, caractérisé par le fait qu'on utilise comme signal délivré sur la borne ($D_0$; PA) de la mémoire à semiconducteurs et possédant la première variation dans le temps, un signal possédant la valeur logique constante "0".

14. Procédé suivant l'une des revendications précédentes, caractérisé par le fait qu'on forme, comme signal possédant la seconde variation dans le temps, un signal qui est complémentaire du signal possédant la première variation dans le temps.

15. Procédé suivant l'une des revendications précédentes, caractérisé par le fait que le circuit d'évaluation (AS) est activé, uniquement lors du fonctionnement d'essai, par un signal d'essai activé (A).

16. Circuit d'évaluation pour la mise en œuvre du procédé suivant l'une des revendications précédentes, caractérisé par le fait
– qu'il comporte un premier circuit comparateur (VS1), qui contient n comparateurs (VS) comportant chacun une première entrée, une seconde entrée et une sortie,
– que toutes les premières entrées des comparateurs (VS) sont reliées entre elles et forment une entrée pour un signal de données de comparaison ($DI_T$),

– que la seconde entrée de chaque comparateur (VS) est reliée respectivement à l'une de n lignes de transmission de données (VS), chaque ligne de transmission de données aboutissant à l'une des n zones de cellules,
– que la sortie de chacun des n comparateurs (VS) forme simultanément l'une de n entrées d'un second circuit comparateur (VS2),
– que le second circuit comparateur (VS2) comporte un dispositif servant à vérifier si la totalité de ses n entrées possède un premier niveau logique,
– que le second circuit comparateur (VS2) possède une première sortie pour un signal d'erreur (F), qui est désactivé dans le cas où la totalité des n entrées de ce circuit possède le premier niveau logique, et, sinon, est activé, et que le second circuit comparateur (VS2) possède une seconde sortie pour un signal ($\overline{F}$) complémentaire du signal d'erreur (F),
– que le circuit d'évaluation (AS) possède d'autre part un circuit de délivrance de résultats (ES), qui comporte une sortie pour un signal de sortie ($AUS_{essai}$) du circuit d'évaluation (AS), qui est délivré en tant que signal possédant une première variation dans le temps sur une borne ($D_0$; PA) du semiconducteur, dans le cas (cas bon), dans lequel la mémoire à semiconducteurs est en ordre, et est disponible en tant que signal possédant une seconde variation temporelle sur la borne ($D_0$; PA) du semiconducteur, dans le cas (cas d'erreur) où la mémoire à semiconducteurs n'est pas en ordre,
– que le circuit de délivrance de résultats (AS) possède en outre des première et seconde entrées, qui sont reliées aux deux sorties du second circuit comparateur (VS2), ainsi qu'une troisième entrée pour un signal, qui détermine, pendant le fonctionnement d'essai, l'état de la borne ($D_0$; PA) du semiconducteur.

17. Circuit d'évaluation suivant la revendication 16, caractérisé par le fait que chaque comparateur (VS) est une porte NON-OU-Exclusif.

18. Circuit d'évaluation suivant la revendication 16, caractérisé par le fait que chaque comparateur (VS) est une porte OU-Exclusif.

19. Circuit d'évaluation suivant l'une des revendications 16 à 18, caractérisé par le fait que le second circuit comparateur (VS2) contient une porte NON-ET comportant n entrées et une sortie, cette sortie formant une sortie du second circuit comparateur (VS2).

20. Circuit d'évaluation suivant l'une des revendications 16 à 18, caractérisé par le fait que le second circuit comparateur (VS2) contient une porte ET comportant n entrées et une sortie, cette sortie formant une sortie du second circuit comparateur (VS2).

21. Circuit d'évaluation suivant l'une des revendications 16 à 20, caractérisé par le fait que le second circuit comparateur (VS2) contient d'autre part un inverseur, dont l'entrée est reliée à une sortie du second circuit comparateur (VS2) et dont la sortie forme l'autre sortie du second circuit comparateur (VS2).

22. Circuit d'évaluation suivant l'une des revendications 16 à 21, caractérisé par le fait que le circuit de délivrance de résultats (ES) comporte deux transistors (M1, M2) et un inverseur (I1), que l'inverseur (I1) est relié, côté sortie, à une borne de la section de conduction d'un transistor (M1), qu'une autre borne de la section de conduction de ce transistor (M1) forme la sortie du circuit d'évaluation de résultats (ES) et que ce transistor (M1) est relié, côté grille, en tant que première entrée du circuit de délivrance de résultats (ES) à une sortie du second circuit comparateur (VS2).

23. Circuit d'évaluation suivant l'une des revendications 16 à 22, caractérisé par le fait que l'autre transistor (M2) du circuit de délivrance de résultats (ES) est branché, par sa section de conduction, entre la troisième entrée et la sortie du circuit de délivrance de résultats (ES), et que cet autre transistor (N2) est relié, par sa grille, en tant que seconde entrée du circuit de délivrance de résultats (ES), à l'autre sortie du second circuit comparateur (VS2).

24. Circuit d'évaluation suivant l'une des revendications 16 à 23, caractérisé par le fait que l'inverseur (I) du circuit de délivrance de résultats (ES) est relié, côté entrée, à la troisième entrée du circuit de délivrance de résultats (ES).

25. Circuit d'évaluation suivant l'une des revendications 16 à 24, caractérisé par le fait que la troisième entrée du circuit de délivrance de résultats (ES) reçoit le signal de données de comparaison (DI$_T$).

26. Circuit d'évaluation suivant l'une des revendications 16 à 24, caractérisé par le fait que la troisième entrée du circuit de délivrance de résultats (ES) est reliée à un potentiel fixe (V$_{DD}$), qui correspond à un "1" logique.

27. Circuit d'évaluation suivant l'une des revendications 16 à 24, caractérisé par le fait que la troisième entrée du circuit de délivrance de résultats (ES) est reliée à un potentiel fixe, qui correspond à un "0" logique.

28. Circuit d'évaluation suivant l'une des revendications 16 à 27, caractérisé par le fait qu'il est prévu, pour la production du signal de données de comparaison (DI$_T$), un tampon d'essai (TB), qui prend en charge une information appliquée à son côté entrée, au moyen d'un signal de lecture (L) pendant un cycle de lecture, au cours duquel une information doit être lue à partir de la mémoire à semiconducteurs, et délivre cette information, côté sortie, en tant que signal de comparaison de données (DI$_T$), au premier circuit comparateur (VS1) et au circuit de délivrance de résultats (ES).

29. Circuit d'évaluation suivant l'une des revendications 16 à 28, caractérisé par le fait que l'information appliquée au côté entrée du tampon d'essai (TB) est un signal (DI), qui est appliqué à une borne d'entrée de données (D$_i$) reliée au tampon d'essai (TB) et qui est identique, au cours du cycle de lecture, à une donnée d'essai qui doit être lue à partir de la mémoire à semiconducteurs.

30. Circuit d'évaluation suivant l'une des revendications 16 à 29, caractérisé par le fait que le signal de lecture (L) est activé pendant un cycle de lecture et qu'il est dérivé, par complémentation, d'un signal (WE) de préparation d'enregistrement/lecture, présent dans la mémoire à semiconducteurs.

31. Circuit d'évaluation suivant l'une des revendications 16 à 30, caractérisé par le fait qu'un signal d'enregistrement (S) est activé pendant un cycle d'enregistrement et qu'il est dérivé du signal (WE) de préparation d'enregistrement/lecture, présent dans la mémoire à semiconducteurs.

32. Circuit d'évaluation suivant l'une des revendications 16 à 31, caractérisé par le fait que les deux circuits comparateurs (VS1, VS2) sont activés uniquement lors de l'essai, par un signal d'essai (T).

# FIG 1

# FIG2

# FIG 3

# FIG 4

FIG 5

FIG 6

FIG 7

FIG 8

FIG 9

FIG 10